(19) Europäisches Patentamt
European Patent Office
Office européen des brevets

(11) **EP 4 227 378 A1**

(12) **EUROPEAN PATENT APPLICATION**
published in accordance with Art. 153(4) EPC

(43) Date of publication:
**16.08.2023 Bulletin 2023/33**

(21) Application number: **21891936.3**

(22) Date of filing: **11.11.2021**

(51) International Patent Classification (IPC):
**C09J 201/00** (2006.01)   **G09F 9/00** (2006.01)
**G09F 9/33** (2006.01)   **H01L 21/60** (2006.01)
**C09J 7/38** (2018.01)

(52) Cooperative Patent Classification (CPC):
**C09J 7/38; C09J 201/00; G09F 9/00; G09F 9/33; H01L 21/60;** H01L 2224/81001; H01L 2224/95001

(86) International application number:
**PCT/JP2021/041471**

(87) International publication number:
**WO 2022/102691 (19.05.2022 Gazette 2022/20)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **13.11.2020 JP 2020189556**

(71) Applicant: SEKISUI CHEMICAL CO., LTD.
**530-0047 (JP)**

(72) Inventors:
• **SUGITA, Daihei**
  **Mishima-gun, Osaka 618-0021 (JP)**
• **HATAI, Munehiro**
  **Mishima-gun, Osaka 618-0021 (JP)**
• **UEDA, Kozo**
  **Mishima-gun, Osaka 618-0021 (JP)**

(74) Representative: **Cabinet Beau de Loménie**
  **158, rue de l'Université**
  **75340 Paris Cedex 07 (FR)**

(54) **METHOD FOR PRODUCING ELECTRONIC COMPONENT, METHOD FOR PRODUCING DISPLAY DEVICE, AND SUPPORT TAPE**

(57)    The present invention aims to provide a method for producing an electronic component that can reduce adhesive deposits on chip components and can transfer chip components with a good yield, a method for producing a display device using the method for producing an electronic component, and a support tape used for the production methods. Provided is a method for producing an electronic component, including: a step (1) of arranging a chip component on a curable adhesive layer of a support tape, the support tape having the curable adhesive layer on at least one surface; a step (2) of performing irradiation with energy rays from a surface of the support tape having the arranged chip component, the surface being opposite to the surface having the chip component stacked thereon; and a step (3) of applying a stimulus from the surface of the support tape opposite to the surface having the chip component stacked thereon, so as to transfer the chip component from the support tape to a next member, the curable adhesive layer containing a polymerizable polymer and a reaction initiator, the curable adhesive layer having a UV absorbance at a wavelength of 365 nm of 95% or greater before the energy ray irradiation, the curable adhesive layer having a UV absorbance at a wavelength of 365 nm of 95% or greater after the energy ray irradiation.

FIG.4

**Description**

TECHNICAL FIELD

The present invention relates to a method for producing an electronic component, a method for producing a display device, and a support tape used for the production methods.

BACKGROUND ART

Micro-LED displays are display devices in which individual chips constituting pixels are micro light emitting diode (LED) chips that emit light by themselves to display images. Micro-LED displays are attracting attention as the next generation of display devices owing to their high contrast, fast response speed, and the potential to be thinner because they do not require color filters used in display devices such as liquid crystal displays and organic EL displays.

In micro-LED displays, a large number of micro-LED chips are densely laid out in a plane. Producing such a micro-LED display involves transferring micro-LED chips to a drive circuit board from a transfer laminate, which includes a large number of micro-LED chips arranged on a transfer substrate having an adhesive layer, to electrically connect the chips to the board.

In the process of transferring micro-LED chips, the micro-LED chips are transferred by separating them from the transfer laminate, with the surface of the transfer laminate having the LED chips arranged thereon facing the surface of the drive circuit board having the electrodes formed thereon.

A known method for separating the micro-LED chips from the transfer laminate is, for example, to irradiate the transfer laminate with laser light focused on the adhesive layer from the back surface of the substrate of the transfer laminate (see, for example, Patent Literature 1). Another known method is to use an adhesive layer containing heat-expandable materials such as heat-expandable particles or heat-expandable microcapsules. The heat-expandable materials are thermally expanded by heat compression bonding of the transfer laminate and the drive circuit board to deform the adhesive layer, whereby the contact area is decreased to separate the micro-LED chips (for example, Patent Literatures 2 and 3).

CITATION LIST

- Patent Literature

Patent Literature 1: JP 2019-138949 A
Patent Literature 2: JP 2019-15899 A
Patent Literature 3: JP 2003-7986 A

SUMMARY OF INVENTION

- Technical problem

However, the method involving laser light irradiation or the method using heat-expandable materials such as heat-expandable particles or heat-expandable microcapsules as disclosed in Patent Literatures 1 to 3 may leave residue of the adhesive layer on the micro-LED chips. Moreover, conventional laser light irradiation methods may fail to separate micro-LED chips due to separation failure, making it difficult to transfer micro-LED chips with a good yield.

The present invention aims to provide a method for producing an electronic component that can reduce adhesive deposits on chip components and can transfer chip components with a good yield, a method for producing a display device using the method for producing an electronic component, and a support tape used for the production methods.

- Solution to problem

The present invention relates to a method for producing an electronic component, including: a step (1) of arranging a chip component on a curable adhesive layer of a support tape, the support tape having the curable adhesive layer on at least one surface; a step (2) of performing irradiation with energy rays from a surface of the support tape having the arranged chip component, the surface being opposite to the surface having the chip component stacked thereon; and a step (3) of applying a stimulus from the surface of the support tape opposite to the surface having the chip component stacked thereon, so as to transfer the chip component from the support tape to a next member, the curable adhesive layer containing a polymerizable polymer and a reaction initiator, the curable adhesive layer having a UV absorbance at a wavelength of 365 nm of 95% or greater before the energy ray irradiation, the curable adhesive layer having a UV absorbance at a wavelength of 365 nm of 95% or greater after the energy ray irradiation.

The present invention is described in detail below.

The method for producing an electronic component of the present invention includes, first, the step (1) of arranging a chip component on a curable adhesive layer of a support tape, the support tape having the curable adhesive layer on at least one surface.

The specific method of the step (1) is not limited. Examples include: a method of individually arranging each chip component on the support tape; a method of bonding a wafer to the support tape and forming it into individual chips; and a method of arranging chip components on a member such as a substrate or an adhesive tape and transferring the chip components onto the support tape. Preferred among these is a method of transferring chip components arranged on a member onto the support tape, as this method provides excellent production efficiency. More specifically, the step (1) is preferably a step of arranging the chip component on the curable adhesive layer of the support tape by bonding the chip component-side surface of a member having the chip component arranged thereon and the support tape, and removing the member.

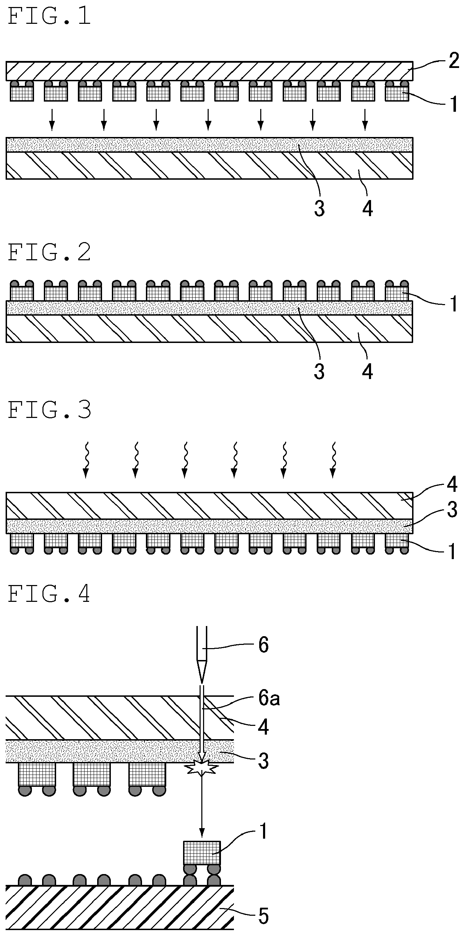

FIGs. 1 and 2 are schematic views illustrating the step (1), particularly the method for transferring the chip component to arrange it on the support tape. In the step (1), as shown in FIG. 1, a member has chip components 1 arranged thereon, and the surface having the chip components 1 arranged thereon is bonded to a curable adhesive layer of a support tape 3 including the curable adhesive layer. In other words, the back surfaces of the chip components 1 are bonded to the curable adhesive layer of the support tape 3. Subsequently, the member 2 is removed by a method such as separation, so as to transfer the chip components 1 onto the curable adhesive layer of the support tape 3 as shown in FIG. 2. The support tape 3 may be a single-sided tape or a double-sided tape, and may or may not include a substrate. When the support tape 3 is a double-sided tape, the surface opposite to the surface onto which the chip components 1 are transferred is preferably bonded to a support 4 such as glass. The member 2 is not limited. Examples thereof include glass substrates, sapphire substrates, silicon substrates, metal substrates, and organic substrates.

The support 4 is not limited. Examples thereof include glass substrates, sapphire substrates, silicon substrates, metal substrates, and organic substrates.

The chip component is not limited. Examples thereof include: micro-LED chips; and optical chips of image sensors. In particular, the chip component is preferably a micro-LED because the method for producing an electronic component of the present invention is particularly highly effective for extremely small chip members that are difficult to separate without adhesive deposits and with a good yield.

The method for producing an electronic component of the present invention includes, next, the step (2) of performing irradiation with energy rays from a surface of the support tape having the arranged chip component, the surface being opposite to the surface having the chip component stacked thereon.

FIG. 3 is a schematic view illustrating the step (2). In the step (2), as shown in FIG. 3, the support tape has chip components arranged on the curable adhesive layer, and irradiation with energy rays is performed from the surface of the support tape opposite to the surface having the chip components stacked thereon. Irradiation with energy rays cures the curable adhesive layer of the support tape 3 and thus decreases the adhesion of the support tape 3, enabling separation of the chip components 1 with reduced adhesive deposits on the chip components 1. Moreover, this allows transfer of normal chips without adhesive deposits, leading to fewer defective products and a higher yield.

The energy rays may be any energy rays that can cure the curable adhesive layer. Examples thereof include ultrasonic waves and light. In particular, for easy curing, the energy rays are preferably light having a wavelength of 300 nm or longer and 450 nm or shorter. The energy level of the energy rays, which is just high enough to cure the curable adhesive layer, is far smaller than the energy level of the later-described stimulus.

When the energy rays are light having a wavelength of 300 nm or longer and 450 nm or shorter, in the step (2), preferably, irradiation with light having a wavelength of 365 nm is performed at an irradiance of 5 mW/cm$^2$ or greater, more preferably an irradiance of 10 mW/cm$^2$ or greater, still more preferably an irradiance of 20 mW/cm$^2$ or greater, particularly preferably an irradiance of 50 mW/cm$^2$ or greater. Also preferably, irradiation with light having a wavelength of 365 nm is performed at an integral irradiance of 300 mJ/cm$^2$ or greater, more preferably an integral irradiance of 500 mJ/cm$^2$ or greater and 10,000 mJ/cm$^2$ or less, still more preferably an integral irradiance of 500 mJ/cm$^2$ or greater and 7,500 mJ/cm$^2$ or less, particularly preferably an integral irradiance of 1,000 mJ/cm$^2$ or greater and 5,000 mJ/cm$^2$ or less.

The method for producing an electronic component of the present invention includes, then, the step (3) of applying a stimulus from the surface of the support tape opposite to the surface having the chip component stacked thereon, so as to transfer the chip component from the support tape to a next member.

FIG. 4 is a schematic view illustrating the step (3). In the step (3), as shown in FIG. 4, the support tape 3 has the chip components 1 arranged thereon, and a stimulus is applied with, for example, light 6a emitted from a light irradiation device 6 from the surface of the support tape 3 opposite to the surface having the chip components stacked thereon, in other words, from the back surface of the support tape. When the stimulus is applied to the support tape 3, the molecules of the curable adhesive are cut by the heat to have low molecular weights, and the resulting molecules instantaneously evaporate or sublimate due to high temperature, thus burning off the portion of the support tape irradiated with light 6a. Thus, applying the stimulus to the support tape 3 at the position above a chip component 1 burns off the support tape, causing the chip component 1 to separate from the support tape 3 to be transferred onto the next member 5. At this time, the curable adhesive layer of the support tape 3 has been cured by the step (2), and thus adhesive deposits are less likely to remain on the chip component 1, allowing separation of the chip component with a lighter force. As a result, adhesive deposits are less likely to remain and the chip component can be transferred, leading to a higher yield. Moreover, the method of separating chip components with a stimulus can induce separation in a very small area. The method thus enables individual separation of chip components with a good yield even when extremely small chip components such as micro-LEDs are arranged. Moreover, as described later, the curable adhesive layer of the support tape 3 has high absorbance of UV light at a specific wavelength, and thus can efficiently convert the stimulus into heat or vibration. This makes it possible to reliably burn off the support tape while causing less unevenness, and also to reduce adhesive deposits as well as separation failure. Although FIG. 4 illustrates the next member 5 as a substrate, the next member 5 is not limited. Examples thereof include glass substrates, sapphire substrates, silicon substrates, metal substrates, organic substrates, drive circuit boards, and adhesive tapes.

The stimulus may be any stimulus that can separate the chip component. Examples thereof include light, heat, electromagnetic waves, and electron rays. In particular, to individually separate even extremely small chip members such as micro-LEDs with a good yield, the stimulus is preferably a laser, more preferably a laser having a wavelength of 300 nm or longer and 370 nm or shorter, still more preferably a laser having a wavelength of 350 nm or longer and 370 nm or shorter. The energy level of the stimulus, which is high enough to burn off the support tape, is far greater than the energy level of the above energy rays.

In the step (3), the stimulus may be applied to the entire support tape, or may be applied individually to each chip component region of the support tape to be separated. Applying a stimulus to the entire support tape is preferred in that it can transfer multiple chip components at once. Applying a stimulus individually to each chip component region of the support tape to be separated is preferred in that it can selectively transfer only a target chip component.

When the stimulus is a laser, the laser preferably has an output of 50 mJ/cm$^2$ or greater and 1,500 mJ/cm$^2$ or less in pulsed irradiation at 5 nsec/pulse.

When the output of the laser is within the range, the laser can sufficiently burn off only the support tape above a target chip component, allowing reliable separation of the chip component with fewer adhesive deposits. Moreover, only the target chip component can be easily selectively transferred. The output of the laser is more preferably 100 mJ/cm$^2$ or greater and 1,000 mJ/cm$^2$ or less.

The curable adhesive layer contains a polymerizable polymer and a reaction initiator.

An adhesive layer containing a polymerizable polymer and a reaction initiator, in other words, containing a curable adhesive, can fix the chip component with sufficient adhesion in the step (1). Curing the curable adhesive layer in the step (2) allows transfer of the chip component without adhesive deposits in the step (3).

The reaction initiator is not limited. Examples thereof include photoreaction initiators and thermal reaction initiators. Preferred among these are photoreaction initiators because they can be activated by energy ray irradiation and cure the curable adhesive layer. UV photoreaction initiators are suitable because they can also function as the later-described UV absorber.

The polymerizable polymer can be obtained by, for example, synthesizing a (meth)acrylic polymer containing a functional group in a molecule (hereinafter the polymer is also referred to as a functional group-containing (meth)acrylic polymer) in advance and reacting the (meth)acrylic polymer with a compound containing a functional group reactive with the above functional group and a radically polymerizable unsaturated bond in a molecule (hereinafter the compound is also referred to as a functional group-containing unsaturated compound). The (meth)acrylic herein means acrylic or methacrylic. The (meth)acrylate means acrylate or methacrylate.

The functional group-containing (meth)acrylic polymer can be obtained by, for example, copolymerizing alkyl acrylate and/or alkyl methacrylate typically having an alkyl group carbon number in the range of 2 to 18, a functional group-containing monomer, and optionally a different modifying monomer copolymerizable with them.

The weight average molecular weight of the functional group-containing (meth)acrylic polymer is not limited, and is typically about 200,000 to 2,000,000.

The weight average molecular weight can be determined by gel permeation chromatography. For example, measurement is performed at 40°C using HSPgelHR MB-M 6.0 × 150 mm as a column and THF as an eluent, and the weight average molecular weight can be determined using polystyrene standards.

Examples of the functional group-containing monomer include carboxy group-containing monomers such as acrylic acid and methacrylic acid, hydroxy group-containing monomers such as hydroxyethyl acrylate and hydroxyethyl methacrylate, and epoxy group-containing monomers such as glycidyl acrylate and glycidyl methacrylate. Examples of the functional group-containing monomer also include isocyanate group-containing monomers such as isocyanate ethyl acrylate and isocyanate ethyl methacrylate and amino group-containing monomers such as aminoethyl acrylate and aminoethyl methacrylate.

Examples of the different copolymerizable modifying monomer include various monomers used for typical (meth)acrylic polymers, such as vinyl acetate, acrylonitrile, and styrene.

The functional group-containing (meth)acrylic polymer may be obtained by radically reacting the raw material monomers under the presence of a polymerization initiator. The method for radially reacting the raw material monomers, that is, the polymerization method, may be a conventionally known method such as solution polymerization (boiling point polymerization or constant temperature polymerization), emulsion polymerization, suspension polymerization, or bulk polymerization.

The polymerization initiator used for the radical reaction to obtain the functional group-containing (meth)acrylic polymer is not limited. Examples thereof include organic peroxides and azo compounds. Examples of the organic peroxides include 1,1-bis(t-hexylperoxy)-3,3,5-trimethylcyclohexane, t-hexyl peroxypivalate, t-butyl peroxypivalate, 2,5-dimethyl-2,5-bis(2-ethylhexanoylperoxy)hexane, t-hexyl peroxy-2-ethylhexanoate, t-butyl peroxy-2-ethylhexanoate, t-butyl peroxyisobutyrate, t-butyl peroxy-3,5,5-trimethylhexanoate, and t-butyl peroxylaurate. Examples of the azo compounds include azobisisobutyronitrile and azobiscyclohexanecarbonitrile. These polymerization initiators may be used alone, or in combination of two or more thereof.

The functional group-containing unsaturated compound to be reacted with the functional group-containing (meth)acrylic polymer may be the same as any of the above functional group-containing monomers depending on the functional group of the functional group-containing (meth)acrylic polymer. For example, when the functional group of the functional group-containing (meth)acrylic polymer is a carboxy group, an epoxy group-containing monomer or an isocyanate group-containing monomer is used. When the functional group of the functional group-containing (meth)acrylic polymer is a hydroxy group, an isocyanate group-containing monomer is used. When the functional group of the functional group-containing (meth)acrylic polymer is an epoxy group, a carboxy group-containing monomer or an amide group-containing monomer such as acrylamide is used. When the functional group of the functional group-containing (meth)acrylic polymer is an amino group, an epoxy group-containing monomer is used.

The curable adhesive layer may contain a radically polymerizable polyfunctional oligomer or monomer. When containing a radically polymerizable polyfunctional oligomer or monomer, the curable adhesive layer has improved photocurability.

The polyfunctional oligomer or monomer is not limited, but preferably has a weight average molecular weight of 10,000 or less. For efficient formation of a three-dimensional network in the curable adhesive layer by light irradiation or heating, the polyfunctional oligomer or monomer preferably has a weight average molecular weight of 5,000 or less and contains 2 to 20 radically polymerizable unsaturated bonds in a molecule.

Examples of the polyfunctional oligomer or monomer include trimethylolpropane triacrylate, tetramethylolmethane tetraacrylate, pentaerythritol triacrylate, pentaerythritol tetraacrylate, dipentaerythritol monohydroxypentaacrylate, dipentaerythritol hexaacrylate, and methacrylates thereof. Examples of the polyfunctional oligomer or monomer also include 1,4-butylene glycol diacrylate, 1,6-hexanediol diacrylate, polyethylene glycol diacrylate, commercial oligoester acrylates, and methacrylates thereof. These polyfunctional oligomers or monomers may be used alone, or in combination of two or more thereof.

The curable adhesive layer preferably contains a UV absorber.

When the curable adhesive layer contains an UV absorber, the later-described UV absorbance can be easily adjusted to a specific range. As a result, the chip component can be separated with fewer adhesive deposits in the step (3), leading to a higher yield. Herein, the UV absorber may be any UV absorber that can absorb light having a wavelength of 200 nm to 400 nm. The UV photoreaction initiator is the reaction initiator and at the same time encompassed by the UV absorber.

The curable adhesive layer preferably contains a UV photoreaction initiator and a UV absorber other than a UV photoreaction initiator. While the UV photoreaction initiator functions as the reaction initiator, the UV photoreaction initiator left unreacted in curing of the curable adhesive layer can be used also as a UV absorber upon separation. Combined use of the UV absorber other than a photoreaction initiator can reduce a decrease in UV absorption even when a large amount of the photoreaction initiator has been consumed by curing of the curable adhesive layer. This facilitates adjustment of the later-described UV absorbance after the energy ray irradiation to a specific range.

The UV photoreaction initiator used may be, for example, activated by irradiation with light at a wavelength of 350 to 370 nm. Examples of such a photopolymerization initiator include acetophenone derivative compounds such as methoxyacetophenone, benzoin ether compounds such as benzoin propyl ether and benzoin isobutyl ether, ketal derivative compounds such as benzyl dimethyl ketal and acetophenone diethyl ketal, and phosphine oxide derivative compounds. Examples further include bis($\mu$5-cyclopentadienyl)titanocene derivative compounds, benzophenone, Michler's ketone, chlorothioxanthone, dodecylthioxanthone, dimethylthioxanthone, diethylthioxanthone, $\alpha$-hydroxycyclohexyl phenyl ketone, and 2-hydroxymethyl phenyl propane. These UV photoreaction initiators may be used alone, or in combination of two or more thereof.

The amount of the UV photoreaction initiator is preferably 1 part by weight or greater relative to 100 parts by weight of the polymerizable polymer.

When the amount of the UV photoreaction initiator is within the range, the curable adhesive layer can be more reliably cured. Moreover, the amount of the unreacted photoreaction initiator remaining after curing can be easily adjusted to an amount large enough to satisfy the later-described range of the UV absorbance. The amount of the UV photoreaction initiator relative to 100 parts by weight of the polymerizable polymer is more preferably 2 parts by weight or greater, still more preferably 3 parts by weight or greater. The upper limit of the amount of the UV photoreaction initiator relative to 100 parts by weight of the polymerizable polymer is not limited. For example, the upper limit is preferably 10 parts by weight or less or 5 parts by weight or less.

The amount of the UV photoreaction initiator is preferably 50% by weight or less relative to 100% by weight of the total of the UV absorbers.

When the amount of the UV photoreaction initiator is within the range, sufficient UV absorption can be maintained even when a large amount of the UV photoreaction initiator has been consumed by curing of the curable adhesive layer. The amount of the UV photoreaction initiator relative to 100% by weight of the total of the UV absorbers is more preferably 40% by weight or less, still more preferably 30% by weight or less. The lower limit of the amount of the UV photoreaction initiator relative to the total of the UV absorbers is not limited. For example, the lower limit is preferably 15% by weight.

The UV absorber other than a UV photoreaction initiator is not limited. Examples thereof include benzotriazole UV photoreaction initiators and hydroxyphenyl triazine UV photoreaction initiators, as well as ethylhexyl methoxycinnamate, octyl methoxycinnamate, ethylhexyl paramethoxycinnamate, hexyl diethylaminohydroxybenzoylbenzoate, bisethylhexyloxyphenolmethoxyphenyltriazine, and t-butylmethoxydibenzoylmethane. Preferred among these are benzotriazole UV photoreaction initiators and hydroxyphenyl triazine UV photoreaction initiators, because they have excellent applicability for compounding in adhesives. The UV absorbers other than a UV photoreaction initiator may be used alone, or in combination of two or more thereof.

The total amount of the UV absorbers is preferably 6 parts by weight or greater relative to 100 parts by weight of the polymerizable polymer.

When the total amount of the UV absorbers is within the range, the stimulus can be more efficiently converted to heat or vibration in the step (3), so that the chip component can be more reliably separated. The total amount of the UV absorbers is more preferably 10 parts by weight or greater, still more preferably 15 parts by weight or greater. The upper limit of the total amount of the UV absorbers is not limited. To ensure the adhesion in the step (1), the total amount is preferably 30 parts by weight or less.

The curable adhesive layer may further contain an inorganic filler such as fumed silica. When containing an inorganic filler, the curable adhesive layer can have higher cohesive force and be attached to an adherend with sufficient adhesion, sufficiently fixing the adherend.

The curable adhesive layer preferably contains a crosslinking agent. When containing a crosslinking agent, the curable adhesive layer can have higher cohesive force and be attached to an adherend with sufficient adhesion, sufficiently fixing the adherend.

The crosslinking agent is not limited. Examples thereof include isocyanate crosslinking agents, epoxy crosslinking agents, aziridine crosslinking agents, and metal chelate crosslinking agents. For higher adhesion, preferred among these are isocyanate crosslinking agents.

The amount of the crosslinking agent relative to 100 parts by weight of the adhesive constituting the curable adhesive layer is preferably 0.01 parts by weight or greater and 20 parts by weight or less. When the amount of the crosslinking agent is within the range, the adhesive can be appropriately crosslinked to have higher adhesion. For higher adhesion, the lower limit of the amount of the crosslinking agent is more preferably 0.05 parts by weight, and the upper limit thereof is more preferably 15 parts by weight. The lower limit is still more preferably 0.1 parts by weight, and the upper limit is still more preferably 10 parts by weight.

The curable adhesive layer may contain known additives such as plasticizers, resins, surfactants, waxes, and fine particle fillers. These additives may be used alone, or in combination of two or more thereof.

The curable adhesive layer has a UV absorbance at a wavelength of 365 nm of 95% or greater before the energy ray irradiation.

When the UV absorbance at a wavelength of 365 nm is within the range before the energy ray irradiation, enough UV absorption to easily separate the chip component without adhesive deposits in the step (3) can be maintained even when the UV photoreaction initiator used as a UV absorber has been consumed by curing of the curable adhesive layer. The UV absorbance at a wavelength of 365 nm before the energy ray irradiation is preferably 98% or greater, more preferably 99% or greater, still more preferably 99.5% or greater. The upper limit of the UV absorbance at a wavelength of 365 nm before the energy ray irradiation is not limited, and the higher, the better. Yet, the UV absorbance at a wavelength of 365 nm before the energy ray irradiation is typically 100% or less. The UV absorbance at a wavelength of 365 nm before the energy ray irradiation can be adjusted by selecting the type of the polymerizable polymer or using a UV absorber. When the support tape is a double-sided adhesive tape having curable adhesive layers on both surfaces, the UV absorbance refers to the UV absorbance of the curable adhesive layer that contacts the chip component.

The UV absorbance at a wavelength of 365 nm before the energy ray irradiation can be obtained by measuring the UV absorbance at 365 nm (initial UV absorbance) using a UV meter (produced by Eye Graphics Co., Ltd., UVPF-A2, or its equivalent product) and a UV lamp.

Specifically, the UV lamp is adjusted such that the irradiation dose at a wavelength of 365 nm is 20 mw/cm$^2$ at one surface of a measurement sample. The UV dose on the UV irradiated surface (before transmission) and the other surface (after transmission) of the measurement sample is measured with the UV meter. The UV absorbance is calculated from the following equation. The irradiation with the UV lamp is performed for 30 seconds for the measurement.

$$\text{UV absorbance} = \{(\text{UV dose before transmission}) - (\text{UV dose after transmission})\}/(\text{UV dose before transmission})\} \times 100\ (\%)$$

The curable adhesive layer has a UV absorbance at a wavelength of 365 nm of 95% or greater after the energy ray irradiation.

With conventional production methods, separating a chip component by laser may leave adhesive that the laser has failed to burn off on the chip component, causing a defective product. With conventional methods, failure to burn off adhesive may prevent separation of the chip component. In the present invention, the UV absorbance at a wavelength of 365 nm after the energy ray irradiation is within the above range. This allows the stimulus in the step (3) to be efficiently converted to heat or vibration, so that the support tape can be more reliably burned off to separate the chip component without adhesive deposits. Moreover, burning off the support tape more reliably can lead to an even higher yield. The UV absorbance at a wavelength of 365 nm after the energy ray irradiation is preferably 96% or greater, more preferably 99% or greater. The upper limit of the UV absorbance at a wavelength of 365 nm before the energy ray irradiation is not limited, and the higher, the better. Yet, the UV absorbance at a wavelength of 365 nm before the energy ray irradiation is typically 100% or less. The UV absorbance at a wavelength of 365 nm after the energy ray irradiation can be adjusted by selecting the type of the polymerizable polymer or using a UV absorber. The UV absorbance at a wavelength of 365 nm after the energy ray irradiation can be obtained by irradiating a measurement sample with UV light at 365 nm to an integral irradiation dose of 3,000 mJ/cm$^2$ using an ultra-high pressure mercury UV irradiator and then performing the same measurement as for the UV absorbance at a wavelength of 365 nm before the energy ray irradiation.

The curable adhesive layer preferably has a gel fraction of 20% by weight or more and 70% by weight or less before the energy ray irradiation. When the gel fraction before the energy ray irradiation is within the range, the curable adhesive layer can be attached to an adherend with sufficient adhesion and sufficiently fix the adherend. For good adhesion, the gel fraction of the curable adhesive layer is more preferably 30% by weight or more, still more preferably 60% by weight or less.

The curable adhesive layer preferably has a gel fraction of 90% or greater after the energy ray irradiation.

When the gel fraction after the energy ray irradiation is within the range, the curable adhesive layer is even less likely to leave adhesive deposits on the chip component and allows separation of the chip component with a lighter force. The gel fraction after the energy ray irradiation is more preferably 93% or greater, still more preferably 95% or greater. The upper limit of the gel fraction after the energy ray irradiation is not limited. Yet, the gel fraction after the energy ray irradiation is preferably 99% or less to reduce unintended separation of the chip component.

The gel fraction can be measured by the following method.

The curable adhesive layer alone is scraped off from the support tape, weighed, and immersed in 50 ml of ethyl acetate. They were shaken with a shaker at a temperature of 23°C at 200 rpm for 24 hours (hereinafter the adhesive layer scraped off is also referred to as an adhesive composition). After shaking, a metal mesh (aperture #200 mesh) is used to separate ethyl acetate and the adhesive composition that has swollen by absorbing ethyl acetate. The separated adhesive composition is dried under the condition of 110°C for one hour. The weight of the adhesive layer composition including the metal mesh after drying is measured, and the gel fraction of the curable adhesive layer is calculated using the following equation.

$$\text{Gel fraction (\% by weight)} = 100 \times (W1 - W2)/W0$$

(W0: the initial weight of the adhesive composition, W1: the weight of the adhesive composition including the metal mesh after drying, W2: the initial weight of the metal mesh)

For the gel fraction after the energy ray irradiation, the curable adhesive layer is cured by irradiation from the substrate side of the support tape with UV light at 365 nm to an integral irradiation dose of 3,000 mJ/cm$^2$ using an ultra-

high pressure mercury UV irradiator, and then the gel fraction is measured.

The curable adhesive layer preferably has a peeling force of 0.5 N/25 mm or less after the energy ray irradiation.

When the peeling force of the curable adhesive layer after the energy ray irradiation is within the range, the chip component can be easily separated with reduced adhesive deposits, leading to a higher yield. The peeling force of the curable adhesive layer after the energy ray irradiation is more preferably 0.3 N/25 mm or less, still more preferably 0.2 N/25 mm or less. The peeling force can be measured by irradiating a measurement sample with UV light at 365 nm to an integral irradiation dose of 3,000 mJ/cm$^2$ using an ultra-high pressure mercury UV irradiator, and then performing a 180° direction peel test in conformity with JIS Z0237 under the conditions of 23°C, a humidity of 50%, and a tensile speed of 300 mm/min.

The thickness of the curable adhesive layer is not limited, but is preferably 200 um or less. When the thickness is 200 um or less, the chip component can be separated with less residue of the curable adhesive layer. The upper limit of the thickness is more preferably 50 um, still more preferably 20 um. The lower limit of the thickness is not limited. To hold the chip component while achieving good separation, the lower limit is preferably 2 $\mu$m, more preferably 5 $\mu$m.

The support tape may be a single-sided adhesive tape or a double-sided adhesive tape. In particular, the support tape is preferably a double-sided adhesive tape because it can be easily attached to a support when a support is used. When the support tape is a double-sided adhesive tape, the support tape has the curable adhesive layer on at least one surface, and may have a curable adhesive layer or non-curable adhesive layer on the other surface. The adhesive layers on both surfaces of the double-sided adhesive tape may contain adhesive of the same or different components.

When the support tape is a double-sided adhesive tape, the double-sided adhesive tape preferably has an energy ray transmittance at 300 to 450 nm of 90% or greater at a surface on which the chip component is not arranged.

When the energy ray transmittance at 300 to 450 nm of the double-sided adhesive tape is 90% or greater at the surface on which the chip component is not arranged, the curable adhesive layer can be more reliably cured in the step (2) even when the support tape is a double-sided adhesive tape including two types of adhesive layers.

The energy ray transmittance at 300 to 450 nm of the double-sided adhesive tape at the surface on which the chip component is not arranged is more preferably 95% or greater.

The support tape may be a supported tape including a substrate or a non-supported tape not including a substrate. For easy handling and cutting, the support tape preferably includes a substrate. The substrate is not limited. To more reliably cure the curable adhesive layer in the step (2), the substrate preferably has an energy ray transmittance at 300 to 450 nm of 90% or greater, more preferably 95% or greater.

Examples of the material of the substrate include polyethylene terephthalate, polyethylene naphthalate, polyacetal, polyamide, polycarbonate, polyphenylene ether, polybutylene terephthalate, ultra-high molecular weight polyethylene, syndiotactic polystyrene, polyarylate, polysulfone, polyether sulfone, polyphenylenesulfide, polyetheretherketone, polyimide, polyetherimide, fluororesin, and liquid crystal polymers. Preferred among these are polyethylene terephthalate and polyethylene naphthalate, because they have excellent heat resistance.

The thickness of the substrate is not limited. The lower limit thereof is preferably 5 um, and the upper limit thereof is preferably 188 um. When the thickness of the substrate is within the range, the support tape can have appropriate stiffness and excellent handleability. The lower limit of the thickness of the substrate is more preferably 12 um, and the upper limit thereof is more preferably 125 $\mu$m.

The method for producing an electronic component of the present invention may be used in any application. The method can produce, with a good yield, an electronic component including any chip component. Still, since the method of the present invention is less likely to cause adhesive deposits on chip components and allows separation of chip components with a lighter force, the method is particularly effective for extremely small chip components that are difficult to transfer without adhesive deposits and with a good yield. The present invention is thus suitable for production of a display device including a micro-LED as a chip component.

The present invention also encompasses such a method for producing a display device, including: a step (1) of arranging a micro-LED chip on a curable adhesive layer of a support tape, the support tape having the curable adhesive layer on at least one surface; a step (2) of performing irradiation with energy rays from a surface of the support tape having the arranged micro-LED chip, the surface being opposite to the surface having the micro-LED chip stacked thereon; and a step (3) of applying a stimulus from the surface of the support tape opposite to the surface having the micro-LED chip stacked thereon, so as to transfer the micro-LED chip from the support tape to a next member, the curable adhesive layer containing a polymerizable polymer and a reaction initiator, the curable adhesive layer having a UV absorbance at a wavelength of 365 nm of 99% or greater before the energy ray irradiation, the curable adhesive layer having a UV absorbance at a wavelength of 365 nm of 95% or greater after the energy ray irradiation.

As for the details of the curable adhesive layer, the support tape, and the steps, the same curable adhesive layer, support tape, and steps and the same methods as those for the method for producing an electronic component may be used.

The method for producing an electronic component and the method for producing a display device of the present invention use a support tape having an UV absorbance at a wavelength of 365 nm within a specific range before and after energy ray irradiation, and thereby reduce adhesive deposits on chip components and micro-LED chips while allowing the chip components and micro-LED chips to more reliably separate from the support tape, leading to a higher yield.

The present invention also encompasses a support tape including a curable adhesive layer on at least one surface, the curable adhesive layer containing a polymerizable polymer and a reaction initiator, the curable adhesive layer having a UV absorbance at a wavelength of 365 nm of 95% or greater before energy ray irradiation, the curable adhesive layer having a UV absorbance at a wavelength of 365 nm of 95% or greater after the energy ray irradiation.

The compositions and the structures of the polymerizable polymer, the reaction initiator, and other components constituting the curable adhesive layer of the support tape of the present invention, the configuration and structure of the portions of the support tape other than the curable adhesive layer, and the methods for measuring the UV absorbance at a wavelength of 365 nm before the energy ray irradiation and the UV absorbance at a wavelength of 365 nm after the energy ray irradiation may be the same as those for the method for producing an electronic component of the present invention.

The support tape of the present invention may be produced by any method. For example, a solution of the polymerizable polymer is mixed with the reaction initiator and optionally other additives such as the UV absorber to prepare an adhesive solution, and the adhesive solution is applied to a release film and dried. This can produce a non-supported support tape including a curable adhesive layer. Alternatively, the curable adhesive layer obtained by the above method may be bonded to a substrate, or the adhesive solution may be applied to a substrate and dried. This can produce a supported, single-sided or double-sided support tape.

- Advantageous Effects of Invention

The present invention can provide a method for producing an electronic component that can reduce adhesive deposits on chip components and can transfer chip components with a good yield, a method for producing a display device using the method for producing an electronic component, and a support tape used for the production methods.

BRIEF DESCRIPTION OF DRAWINGS

FIG. 1 is a schematic view illustrating an exemplary step (1) of the method for producing an electronic component of the present invention.
FIG. 2 is a schematic view illustrating an exemplary step (1) of the method for producing an electronic component of the present invention.
FIG. 3 is a schematic view illustrating an exemplary step (2) of the method for producing an electronic component of the present invention.
FIG. 4 is a schematic view illustrating an exemplary step (3) of the method for producing an electronic component of the present invention.

DESCRIPTION OF EMBODIMENTS

The embodiments of the present invention are described in more detail below with reference to, but not limited to, examples.

(Synthesis of polymerizable polymer)

A reactor equipped with a thermometer, a stirrer, and a condenser was provided. The reactor was charged with 51 parts by weight of 2-ethylhexyl acrylate and 37 parts by weight of isobornyl acrylate as alkyl (meth)acrylates, 1 part by weight of acrylic acid and 19 parts by weight of hydroxyethyl methacrylate as functional group-containing monomers, 0.01 parts by weight of laurylmercaptan, and 80 parts by weight of ethyl acetate, and then heated to start reflux. Subsequently, 0.01 parts by weight of 1,1-bis(t-hexylperoxy)-3,3,5-trimethylcyclohexane as a polymerization initiator was added into the reactor to start polymerization under reflux. Then, 0.01 parts by weight of 1,1-bis(t-hexylperoxy)-3,3,5-trimethylcyclohexane was added one hour after and two hours after the start of polymerization. Four hours after the start of polymerization, 0.05 parts by weight of t-hexyl peroxypivalate was added to continue the polymerization reaction. Eight hours after the start of polymerization, an ethyl acetate solution of a functional group-containing (meth)acrylic polymer with a solid content of 55% by weight and a weight average molecular weight of 600,000 was obtained.

To 100 parts by weight of the resin solids of the ethyl acetate solution containing a functional group-containing (meth)acrylic polymer was added 12 parts by weight of 2-isocyanatoethyl methacrylate for reaction, whereby an ethyl acetate solution of a (meth)acrylic polymer (polymerizable polymer) was obtained.

(Example 1)

(1) Support tape production 1

One hundred parts by weight of the resin solids (polymerizable polymer) of the obtained ethyl acetate solution of the polymerizable polymer was mixed with 1.25 parts by weight of a crosslinking agent (S-DINE curing agent UA, produced by Sekisui Fuller Company, Ltd.), 1 part by weight of a photoreaction initiator (UV photoreaction initiator, Omnirad 651, produced by Toyotsu Chemiplas Corporation), and 5 parts by weight of a UV absorber (Tinuvin 928, produced by FUJIFILM Wako Pure Chemical Corporation). This produced an ethyl acetate solution of a curable adhesive.

Subsequently, the obtained curable adhesive solution was applied with a doctor knife to a corona-treated 50-μm-thick PET film (substrate) to a dry film thickness of 20 μm, and left to stand at room temperature for 10 minutes. Then, the applied solution was dried at 110°C for 5 minutes in an oven preheated to 110°C, whereby a support tape including a curable adhesive layer and a substrate was obtained.

(2) Measurement of peeling force

The surface of a 1-mm-thick SUS plate was washed with ethanol and sufficiently dried. The support tape was cut to a width of 25 mm and a length of 10 cm in advance. The curable adhesive layer side of the support tape was placed on the SUS plate, and a 2-kg roller was moved back and force once thereon, whereby a measurement sample was obtained.

The obtained measurement sample was subjected to a peel test in conformity with JIS Z0237 using Autograph (produced by Shimadzu Corporation). In the test, the support tape was peeled off in a 180° direction at a tensile speed of 300 mm/min in an environment of a temperature of 23°C and a relative humidity of 50%, and the initial peeling force was measured.

Another measurement sample was prepared in the same manner. The support tape side of the sample was irradiated with UV light at 365 nm to an integral irradiation dose of 3,000 mJ/cm$^2$ using an ultra-high pressure mercury UV irradiator. The irradiance was adjusted such that the irradiation intensity was 100 mW/cm$^2$. The measurement sample was then subjected to a peel test in the same manner as for the initial peeling force, and the peeling force after the energy ray irradiation was measured. Table 1 shows the results.

(3) Measurement of UV absorbance

A measurement sample consisting only of a curable adhesive layer was prepared in the above method. With the obtained sample, the absorbance of UV light at 365 nm (initial UV absorbance) was measured by the following method using a UV meter (produced by Eye Graphics Co., Ltd., UVPF-A2) and a UV lamp.

The UV lamp was adjusted such that the irradiation dose at a wavelength of 365 nm was 20 mw/cm$^2$ at one surface of the measurement sample. The UV dose on the UV irradiated surface (before transmission) and the other surface (after transmission) of the measurement sample was measured with the UV meter. The UV absorbance was calculated from the following equation. The irradiation with the UV lamp was performed for 30 seconds for the measurement.

```
UV absorbance = {(UV dose before transmission) - (UV dose
after transmission)}/(UV dose before transmission)} × 100
(%)
```

Subsequently, the measurement sample was irradiated with UV light at 365 nm to an integral irradiation dose of 3,000 mJ/cm$^2$ using an ultra-high pressure mercury UV irradiator. Then, the absorbance of UV light at 365 nm (UV absorbance after energy ray irradiation) was measured. Table 1 shows the results.

(4) Measurement of gel fraction after energy ray irradiation

The obtained support tape was cut to 200 mm × 200 mm. The curable adhesive layer was cured by irradiation from the substrate side of the cut support tape with UV light at 365 nm to an integral irradiation dose of 3,000 mJ/cm$^2$ using an ultra-high pressure mercury UV irradiator. The curable adhesive layer alone was then scraped off from the cured support tape, weighed in an amount of 0.1 g, immersed in 50 ml of ethyl acetate, and shaken with a shaker under the conditions of a temperature of 23°C and 200 rpm for 24 hours (hereinafter the adhesive layer scraped off was also referred to as an adhesive composition). After shaking, a metal mesh (aperture #200 mesh) was used to separate ethyl acetate and the adhesive composition that had swollen by absorbing ethyl acetate. The separated adhesive composition was dried under the condition of 110°C for one hour. The weight of the adhesive composition including the metal mesh after drying was measured, and the gel fraction of the curable adhesive layer after energy ray irradiation was calculated using the following equation. Table 1 shows the results.

$$\texttt{Gel fraction (\% by weight) = 100 × (W1 - W2)/W0}$$

(W0: the initial weight of the adhesive composition, W1: the weight of the adhesive composition including the metal mesh after drying, W2: the initial weight of the metal mesh)

(Examples 2 to 6 and Comparative Examples 1 and 2)

A support tape was obtained as in Example 1 except that the compounding amounts of the photoreaction initiator and the UV absorber were as shown in Table 1. The support tape was subjected to the measurements. Table 1 shows the results.

(Example 7)

(Support tape production 2)

One hundred parts by weight of the resin solids (polymerizable polymer) of the obtained ethyl acetate solution of the polymerizable polymer was mixed with 1.25 parts by weight of a crosslinking agent (S-DINE curing agent UA, produced by Sekisui Fuller Company, Ltd.), 1 part by weight of a photoreaction initiator (UV photoreaction initiator, Omnirad TPO, produced by Toyotsu Chemiplas Corporation), and 5 parts by weight of a UV absorber (Tinuvin 479, produced by FUJIFILM Wako Pure Chemical Corporation). This produced an ethyl acetate solution of a curable adhesive.
Subsequently, the obtained curable adhesive solution was applied with a doctor knife to a corona-treated 50-$\mu$m-thick PET film (substrate) to a dry film thickness of 20 $\mu$m, and left to stand at room temperature for 10 minutes. Then, the applied solution was dried at 110°C for 5 minutes in an oven preheated to 110°C, whereby a support tape including a curable adhesive layer and a substrate was obtained. The obtained support tape was subjected to the measurements as in Example 1. Table 1 shows the results.

<Evaluation>

The examples and the comparative examples were evaluated by the following methods. Table 1 shows the results.

(Processing of chip components)

A wafer on which 10 Si chips (500 um × 500 um square, thickness 50 $\mu$m) were arranged was provided. The Si chip side surface of the wafer and the curable adhesive layer side of the support tape were bonded, and the wafer was then removed to transfer the Si chips onto the support tape. Subsequently, the curable adhesive layer was cured by irradiation from the substrate side of the support tape with UV light at 365 nm to an integral irradiation dose of 3,000 mJ/cm$^2$ using a high pressure mercury UV irradiator (GWSM-300R, produced by Takatori Corporation). A semiconductor solid-state laser was then used to irradiate each Si chip with a laser at 365 nm with an output of 4 W and 4 kHz from the substrate side of the support tape, so as to separate the Si chips from the support tape.

(1) Evaluation of separability

In the processing of the chip components, separated Si chips were counted.
The evaluation on the chip separability was carried out based on the following criteria: "o" (Good) indicates that all the 10 Si chips were separated; "Δ" (Fair) indicates that 8 or 9 Si chips were separated; and "×" (Poor) indicates that 7 or less Si chips were separated.

(2) Evaluation of adhesive deposits

The surface of a Si chip after the processing of the chip components was observed under a microscope to determine the presence or absence of adhesive deposits. The evaluation of adhesive deposits was carried out based on the following criteria: "o" (Good) indicates no adhesive deposit was observed; "Δ" (Fair) indicates that slight adhesive deposits were observed (less than 20% of the surface of the chip); and "×" (Poor) indicates that a large amount of adhesive deposits were observed (20% or more of the surface of the chip).

[Table 1]

| | | | Example 1 | Example 2 | Example 3 | Example 4 | Example 5 | Example 6 | Example 7 | Comparative Example 1 | Comparative Example 2 |
|---|---|---|---|---|---|---|---|---|---|---|---|
| Composition of curable adhesive layer | Polymerizable polymer (parts by weight) | | 100 | 100 | 100 | 100 | 100 | 100 | 100 | 100 | 100 |
| | UV absorber (parts by weight) | Tinuvin 928 | 5 | 6 | 4.5 | 4 | 5.5 | 6 | - | 4 | 3 |
| | | Tinuvin 479 | - | - | - | - | - | - | 5 | - | - |
| | UV photoreaction initiator (parts by weight) | Omnirad 651 | 1 | 2 | 1 | 4.5 | 0.5 | 0.3 | - | 1 | 3 |
| | | Omnirad TPO | - | - | - | - | - | - | 1 | - | - |
| Physical properties | Initial peeling force (N/25 mm) | | 5 | 4 | 6 | 3.5 | 5.2 | 4.5 | 4.5 | 5.5 | 4.7 |
| | Peeling force after energy ray irradiation (N/25 mm) | | 0.2 | 0.1 | 0.3 | 0.1 | 0.4 | 0.55 | 0.2 | 0.2 | 0.2 |
| | Initial UV absorbance (%) | | 99.3 | 99.8 | 98.5 | 99.9 | 99.3 | 99.6 | 99.4 | 97.2 | 99.6 |
| | UV absorbance after energy ray irradiation (%) | | 99 | 99.3 | 96.5 | 97.5 | 99.3 | 99.3 | 99.1 | 94.3 | 83.1 |
| | Gel fraction after energy ray irradiation (%) | | 92 | 95 | 95 | 96.5 | 87.6 | 84.3 | 93 | 93 | 97 |
| Evaluation | Separability | | ○ | ○ | △ | △ | ○ | △ | ○ | × | × |
| | Adhesive deposit | | ○ | ○ | ○ | ○ | △ | △ | ○ | ○ | × |

EP 4 227 378 A1

13

INDUSTRIAL APPLICABILITY

The present invention can provide a method for producing an electronic component that can reduce adhesive deposits on chip components and can transfer chip components with a good yield, a method for producing a display device using the method for producing an electronic component, and a support tape used for the production methods.

REFERENCE SIGNS LIST

| 1 | chip component |
|---|---|
| 2 | member |
| 3 | support tape |
| 4 | support |
| 5 | next member |
| 6 | light irradiation device |
| 6a | light |

**Claims**

1. A method for producing an electronic component, comprising:

   a step (1) of arranging a chip component on a curable adhesive layer of a support tape, the support tape having the curable adhesive layer on at least one surface;
   a step (2) of performing irradiation with energy rays from a surface of the support tape having the arranged chip component, the surface being opposite to the surface having the chip component stacked thereon; and
   a step (3) of applying a stimulus from the surface of the support tape opposite to the surface having the chip component stacked thereon, so as to transfer the chip component from the support tape to a next member,
   the curable adhesive layer containing a polymerizable polymer and a reaction initiator,
   the curable adhesive layer having a UV absorbance at a wavelength of 365 nm of 95% or greater before the energy ray irradiation,
   the curable adhesive layer having a UV absorbance at a wavelength of 365 nm of 95% or greater after the energy ray irradiation.

2. The method for producing an electronic component according to claim 1,
   wherein the energy rays are light having a wavelength of 300 nm or longer and 450 nm or shorter.

3. The method for producing an electronic component according to claim 1 or 2,
   wherein the stimulus is a laser having a wavelength of 300 nm or longer and 370 nm or shorter.

4. The method for producing an electronic component according to any one of claims 1 to 3,
   wherein the curable adhesive layer contains a UV absorber.

5. The method for producing an electronic component according to claim 4,
   wherein the curable adhesive layer contains a UV photoreaction initiator and a UV absorber other than a UV photoreaction initiator.

6. The method for producing an electronic component according to claim 4 or 5,
   wherein the total amount of the UV absorbers is 6 parts by weight or greater relative to 100 parts by weight of the polymerizable polymer.

7. The method for producing an electronic component according to claim 5 or 6,
   wherein the amount of the UV photoreaction initiator is 1 part by weight or greater relative to 100 parts by weight of the polymerizable polymer and is 50% by weight or less relative to 100% by weight of the total of the UV absorbers.

8. The method for producing an electronic component according to any one of claims 1 to 7,
   wherein the curable adhesive layer has a UV absorbance of 99% or greater after the energy ray irradiation.

9. The method for producing an electronic component according to any one of claims 1 to 8,
   wherein the curable adhesive layer has a gel fraction of 90% or greater after the energy ray irradiation.

10. The method for producing an electronic component according to any one of claims 1 to 9,
    wherein the curable adhesive layer has a peeling force of 0.5 N/25 mm or less after the energy ray irradiation.

11. The method for producing an electronic component according to any one of claims 1 to 10,
    wherein the support tape is a double-sided adhesive tape, and the double-sided adhesive tape includes, on a surface on which the chip component is not arranged, an adhesive layer having an energy ray transmittance at 300 to 450 nm of 90% or greater.

12. The method for producing an electronic component according to any one of claims 1 to 11,
    wherein the support tape includes a substrate, and the substrate has an energy ray transmittance at 300 to 450 nm of 90% or greater.

13. A method for producing a display device, comprising:

    a step (1) of arranging a micro-LED chip on a curable adhesive layer of a support tape, the support tape having the curable adhesive layer on at least one surface;
    a step (2) of performing irradiation with energy rays from a surface of the support tape having the arranged micro-LED chip, the surface being opposite to the surface having the micro-LED chip stacked thereon; and
    a step (3) of applying a stimulus from the surface of the support tape opposite to the surface having the micro-LED chip stacked thereon, so as to transfer the micro-LED chip from the support tape to a next member,
    the curable adhesive layer containing a polymerizable polymer and a reaction initiator,
    the curable adhesive layer having a UV absorbance at a wavelength of 365 nm of 99% or greater before the energy ray irradiation,
    the curable adhesive layer having a UV absorbance at a wavelength of 365 nm of 95% or greater after the energy ray irradiation.

14. A support tape comprising a curable adhesive layer on at least one surface,

    the curable adhesive layer containing a polymerizable polymer and a reaction initiator,
    the curable adhesive layer having a UV absorbance at a wavelength of 365 nm of 95% or greater before energy ray irradiation,
    the curable adhesive layer having a UV absorbance at a wavelength of 365 nm of 95% or greater after the energy ray irradiation.

FIG.1

FIG.2

FIG.3

FIG.4

## INTERNATIONAL SEARCH REPORT

| | International application No. |
|---|---|
| | **PCT/JP2021/041471** |

### A. CLASSIFICATION OF SUBJECT MATTER

*C09J 201/00*(2006.01)i; *G09F 9/00*(2006.01)i; *G09F 9/33*(2006.01)i; *H01L 21/60*(2006.01)i; *C09J 7/38*(2018.01)i
FI:  H01L21/60 311Q; G09F9/00 338; G09F9/33; C09J7/38; C09J201/00

According to International Patent Classification (IPC) or to both national classification and IPC

### B. FIELDS SEARCHED

Minimum documentation searched (classification system followed by classification symbols)

C09J201/00; G09F9/00; G09F9/33; H01L21/60; C09J7/38

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| Y | JP 2017-135397 A (BONDTECH INC) 03 August 2017 (2017-08-03)<br>    paragraphs [0168]-[0186] | 1-14 |
| Y | US 2018/0374738 A1 (SAMSUNG ELECTRONICS CO., LTD.) 27 December 2018 (2018-12-27)<br>    paragraphs [0021], [0033], [0034] | 1-14 |
| Y | JP 2005-5494 A (SONY CORP) 06 January 2005 (2005-01-06)<br>    paragraphs [0018], [0043]-[0050] | 1-14 |

☐ Further documents are listed in the continuation of Box C.  ☑ See patent family annex.

| | |
|---|---|
| *    Special categories of cited documents: | "T"  later document published after the international filing date or priority date and not in conflict with the application but cited to understand the principle or theory underlying the invention |
| "A"  document defining the general state of the art which is not considered to be of particular relevance | |
| "E"  earlier application or patent but published on or after the international filing date | "X"  document of particular relevance; the claimed invention cannot be considered novel or cannot be considered to involve an inventive step when the document is taken alone |
| "L"  document which may throw doubts on priority claim(s) or which is cited to establish the publication date of another citation or other special reason (as specified) | "Y"  document of particular relevance; the claimed invention cannot be considered to involve an inventive step when the document is combined with one or more other such documents, such combination being obvious to a person skilled in the art |
| "O"  document referring to an oral disclosure, use, exhibition or other means | |
| "P"  document published prior to the international filing date but later than the priority date claimed | "&"  document member of the same patent family |

| Date of the actual completion of the international search | Date of mailing of the international search report |
|---|---|
| **06 January 2022** | **18 January 2022** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (January 2015)

**INTERNATIONAL SEARCH REPORT**
Information on patent family members

International application No.

**PCT/JP2021/041471**

| Patent document cited in search report | | | Publication date (day/month/year) | Patent family member(s) | Publication date (day/month/year) |
|---|---|---|---|---|---|
| JP | 2017-135397 | A | 03 August 2017 | (Family: none) | |
| US | 2018/0374738 | A1 | 27 December 2018 | CN 109121318 A paragraphs [0022], [0034], [0035] KR 10-2019-0000582 A | |
| JP | 2005-5494 | A | 06 January 2005 | (Family: none) | |

Form PCT/ISA/210 (patent family annex) (January 2015)

**EP 4 227 378 A1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2019138949 A
- JP 2019015899 A
- JP 2003007986 A